Europäisches Patentamt

European Patent Office

Office européen des brevets

(19)

(11) Veröffentlichungsnummer: **0 387 732**
**A2**

# EUROPÄISCHE PATENTANMELDUNG

(12)

(21) Anmeldenummer: **90104590.6**

(22) Anmeldetag: **10.03.90**

(51) Int. Cl.⁵: **G01R 31/04**

Die Bezeichnung der Erfindung wurde geändert (Richtlinien für die Prüfung im EPA, A-III, 7.3).

(30) Priorität: **15.03.89 DE 3908361**

(43) Veröffentlichungstag der Anmeldung:
**19.09.90 Patentblatt 90/38**

(84) Benannte Vertragsstaaten:
**DE FR GB IT SE**

(71) Anmelder: **STOCKO Metallwarenfabriken Henkels und Sohn GmbH & Co**
**Kirchhofstrasse 52a**
**D-5600 Wuppertal 1(DE)**

(72) Erfinder: **Kamps, Rolf**
**Hürdenstrasse 8**
**D-5600 Wuppertal 11(DE)**
Erfinder: **Ströter, Hermann**
**Hilgershöhe 42**
**D-5600 Wuppertal 2(DE)**

(74) Vertreter: **Patentanwälte Dipl.-Ing. Alex Stenger Dipl.-Ing. Wolfram Watzke Dipl.-Ing. Heinz J. Ring**
**Kaiser-Friedrich-Ring 70**
**D-4000 Düsseldorf 11(DE)**

(54) **Prüfvorrichtung für Steckverbinder.**

(57) Eine Prüfvorrichtung zum Prüfen der richtigen Lage eines an einem elektrischen Steckverbinder 1 in Schneidklemmtechnik elektrisch kontaktierten elektrischen Leiters 2 besteht aus einer Halteeinrichtung 3 zum Fixieren des elektrischen Steckverbinders 1 in einer vorgegebenen Position. Ein Prüfstift 5 dieser Halteeinrichtung ist mit dem Federkontakt 12 des elektrischen Steckverbinders 1 elektrisch kontaktiert. Weiterhin ist ein Prüfkopf 8 mit einer Prüfspitze vorgesehen, der in eine vorgegebene Position derart verfahrbar ist, daß die Prüfspitze nur dann mit dem elektrischen Leiter elektrisch kontaktierbar ist, wenn dieser sich in seiner Sollposition befindet.

Fig. 1

# Prüfvorrichtung

Die Erfindung betrifft eine Prüfvorrichtung zum Prüfen der richtigen Kontaktierung sowie insbesondere der richtigen Lage eines an einem elektrischen Steckverbinder in Schneidklemmtechnik elektrisch kontaktierten elektrischen Leiters, wobei der elektrische Steckverbinder aus einem Steckergehäuse besteht, in dem eine einen Federkontakt für einen Kontaktstift der elektrischen Steckverbindung sowie einen Schneidklemmkontakt aufweisende Schneidkontaktfeder angeordnet ist, die Prüfvorrichtung mit einer den elektrischen Steckverbinder in einer vorgegebenen Position fixierenden Halteeinrichtung, an der ein Prüfstift angeordnet ist, der im fixierten Zustand des elektrischen Steckverbinders mit dem Federkontakt der Schneidkontaktfeder elektrisch kontaktiert ist, sowie mit einer am Prüfstift angeschlossenen elektrischen Auswerteeinrichung zum Anlegen eines Prüfsignals.

Elektrische Steckverbinder, bei denen die elektrischen Leiter in der sogenannten Schneidklemmtechnik elektrisch kontaktierbar sind, sind bekannt. Unter einem elektrischen Leiter wird dabei ein Kabel verstanden, bei dem ein Draht von Isolationsmaterial umschlossen ist. Mehrere dieser elektrischen Leiter können zu einer Flachbandleitung zusammengefaßt sein. Der elektrische Steckverbinder besteht dabei grundsätzlich aus einem Steckergehäuse aus Kunststoff, in dem eine Schneidkontaktfeder angeordnet ist, welche den elektrischen Steckkontakt zwischen dem elektrischen Leiter und einem Kontaktstift der elektrischen Steckverbindung herstellt, wobei dieser Kontaktstift beispielsweise Teil eines Stiftgehäuses sein kann.

Zu diesem Zweck besteht die Schneidkontaktfeder aus einem Federkontakt und einem daran einstückigen Schneidklemmkontakt. Der Federkontakt kann dabei beispielsweise als Gabelfeder ausgebildet sein, wobei zwischen die beiden Zinken dieser Gabelfeder der Kontaktstift derart einschiebbar ist, daß die beiden Zinken zur Herstellung des elektrischen Kontaktes nach außen gebogen werden. Der Schneidklemmkontakt der Schneidkontaktfeder dient der elektrischen Kontaktierung des elektrischen Leiters in der Schneidklemmtechnik. Dabei bilden zwei zueinander parallele Messer des Schneidklemmkontaktes zwischen sich einen Spalt, in den der elektrische Leiter derart eingeschoben wird, daß die Messer das Isolationsmaterial durchtrennen und dabei in Kontakt mit dem Draht gelangen, so daß auf diese Weise die elektrische Kontaktierung hergestellt ist. Das Ansetzen eines Leiters bzw. einer entsprechenden Flachbandleitung kann mittels einer Ansetzzange oder einer Ansetzmaschine erfolgen.

Aus der US-PS 4 734 651 ist eine Prüfvorrichtung zum Prüfen der richtigen Kontaktierung eines an einem elektrischen Steckverbinder in Schneidklemmtechnik elektrisch kontaktierten elektrischen Leiters bekannt. Unter einem elektrischen Leiter wird dabei ein Kabel verstanden, bei dem ein Draht von Isolationsmaterial umschlossen ist. Mehrere dieser elektrischen Leiter können zu einer Flachbandleitung zusammengefaßt sein. Der elektrische Steckverbinder, bei dem der elektrische Leiter in der sogenannten Schneidklemmtechnik elektrisch kontaktierbar ist, besteht aus einem Steckergehäuse aus Kunststoff, in dem eine Schneidkontaktfeder angeordnet ist, welche den elektrischen Steckkontakt zwischen dem elektrischen Leiter und einem Kontaktstift der elektrischen Steckverbindung herstellt, wobei dieser Kontaktstift beispielsweise Teil eines Stiftgehäuses sein kann. Zu diesem Zweck besteht die Schneidkontaktfeder aus einem Federkontakt und einem daran einstückigen Schneidklemmkontakt, wobei der Fe derkontakt als Gabelfeder ausgebildet ist, zwischen dessen Zinken der Kontaktstift derart einschiebbar ist, daß die beiden Zinken zur Herstellung des elektrischen Kontaktes nach außen gebogen werden. Der Schneidklemmkontakt der Schneidkontaktfeder dient der elektrischen Kontaktierung des elektrischen Leiters in der sogenannten Schneidklemmtechnik. Dabei bilden zwei zueinander parallele, messerartige Schenkel des Schneidklemmkontaktes zwischen sich einen Spalt, in den der elektrische Leiter derart eingeschoben wird, daß das Isolationsmaterial durchtrennt wird und dabei die Schenkel in Kontakt mit dem Draht gelangen, so daß auf diese Weise die elektrische Kontaktierung hergestellt ist. Das Ansetzen des Leiters erfolgt mittels einer Ansetzmaschine.

Der bekannte elektrische Steckverbinder mit den in Schneidklemmtechnik elektrisch kontaktierten elektrischen Leitern kann mittels der Prüfvorrichtung auf Durchgang, also auf richtige Kontaktierung geprüft werden. Zu diesem Zweck wird der elektrische Steckverbinder mittels einer Halteeinrichtung in einer vorgegebenen Position fixiert. Ein Prüfstift der Prüfvorrichtung wird in Kontakt mit dem Federkontakt der Schneidkontaktfeder gebracht. Durch Anlegen eines Prüfsignals durch eine angeschlossene Auswerteeinrichtung kann in Erfahrung gebracht werden, ob der elektrische Leiter richtig kontaktiert ist. Zu diesem Zweck wird ein Oszillatorsignal angelegt, welches sich dann hinsichtlich Phase und Amplitude ändert, wenn eine richtige Kontaktierung vorliegt. Diese Änderung des Prüfsignals ist dann der Nachweis dafür, daß die Kontaktierung richtig erfolgt ist.

Über die Lage des elektrischen Leiters im Schneidklemmspalt kann jedoch mittels der Prüfvorrichtung keine Aussage gemacht werden. Insbesondere kann keine Prüfung dahingehend vorgenommen werden, ob die Leiterenden deformiert sind oder ob bei den Leitern das Isolationsmaterial vorsteht. Eine derartige Prüfung wäre jedoch notwendig, um eine einwandfreie Funktionssicherheit des elektrischen Steckverbinders zu gewährleisten.

Davon ausgehend liegt der Erfindung die **Aufgabe** zugrunde, die bekannte Prüfvorrichtung derart weiterzuentwickeln, daß mit ihr auch eine Prüfung der richtigen Lage des an einem elektrischen Steckverbinder in Schneidklemmtechnik elektrisch kontaktierten elektrischen Leiters möglich ist.

Die technische **Lösung** ist gekennzeichnet durch einen eine Prüfspitze aufweisenden und bezüglich zur Halteeinrichtung derart verfahrbaren Prüfkopf, daß beim Verfahren in eine vorgegebene Position das vordere Ende der Prüfspitze mit dem hinter einem von außen zugänglichen Fenster im Steckergehäuse liegenden Ende des elektrischen Leiters elektrisch kontaktiert ist, sofern sich dieses in seiner Sollposition befindet, wobei die elektrische Auswerteeinrichtung außer am Prüfstift noch an dieser Prüfspitze des Prüfkopfes angeschlossen ist.

Mittels einer derartigen Prüfeinrichtung kann außer der richtigen Kontaktierung geprüft werden, ob der elektrische Leiter im Toleranzbereich des Schneidklemmkontaktes angesetzt wurde. Dies stellt eine sehr einfache und preiswerte und vor allem auch eine sehr schnelle Prüfung der richtigen Kontaktierung dar, wobei die Prüfvorrichtung wenig störanfällig und wartungsfreundlich ist. Sie kann auch in bestehende Maschinen auf technisch einfache Weise nachgerüstet werden. Grundsätzlich kann die Prüfvorrichtung für alle Schneidkontaktierungen genutzt werden, wo das Leiterende durch ein Fenster im Steckergehäuse zugänglich ist. Schließlich ist mit der Prufvorrichtung vor allem auch eine sichere Prüfung durchführbar, da der Draht des elektrischen Leiters geprüft wird und nicht das den Draht umgebende Isolationsmaterial. Die Prüfspitze ist dabei derart geformt, daß stirnseitig überstehendes Isolationsmaterial oder Leitermaterial verdrängt wird, so daß eine einwandfreie Lageüberprüfung des Endes des elektrischen Leiters möglich ist. Der metallische Prüfstift der Halteeinrichtung sowie die metallische Prüfspitze des verfahrbaren Prüfkopfes sind dabei an einer elektrischen Auswerteeinrichtung angeschlossen, die überprüft, ob zwischen dem Prüfstift und der Prüfspitze ein (Kurzschluß-)Strom fließt. Dieser fließt nur dann, wenn sich das Ende des elektrischen Leiters in der Sollposition befindet, so daß die Prüfspitze des Prüfkopfes mit dem Draht des elektrischen Leiters elektrisch kontaktiert ist. Befindet sich das Ende des elektrischen Leiters nicht in seiner Sollposition, so steht auch die Prüfspitze nicht im elektrischen Kontakt mit dem Draht des elektrischen Leiters, so daß kein Strom von dem Prüfstift über die Schneidkontaktfeder sowie über den Draht des elektrischen Leiters zur Prüfspitze fließen kann. Diese Stromunterbrechung ist dann ein Indiz dafür, daß sich das Ende des elektrischen Leiters nicht in seiner Sollposition befindet. Mittels der Prüfvorrichtung ist es somit möglich, über die Lage des elektrischen Leiters, also über seine Kontaktiertiefe und seinen Drahtüberstand im Schneidklemmspalt eine Aussage zu machen.

Vorzugsweise ist der Prüfstift der Halteeinrichtung federbelastet. Auf diese Weise ist eine sichere elektrische Kontaktierung zwischen dem Prüfstift und dem Federkontakt der Schneidkontaktfeder herstellbar.

In einer vorteilhaften Weiterbildung der Prüfspitze ist diese derart geometrisch geformt, daß ein Toleranzbereich der Lage des zu prüfenden elektrischen Leiters ermittelbar ist. Durch die Vorgabe eines derartigen Toleranzbereiches durch eine entsprechende Ausbildung des vorderen Endes der Prüfspitze kann der angesetzte elektrische Leiter in Breiten- und Höhenlage abgefragt werden.

Vorzugsweise ist die Prüfspitze des Prüfkopfes ein Prüfstift oder ein Prüfmesser.

In einer Weiterbildung des Prüfkopfes ist dieser zusammen mit der Prüfspitze in Richtung der Längserstreckung des elektrischen Leiters verfahrbar. Die Prüfspitze ist dabei in Richtung des elektrischen Leiters ausgerichtet.

Um den Prüfkopf exakt in seine vorgegebene Position verfahren zu können, ist in einer Weiterbildung zwischen der Halteeinrichtung und dem Prüfkopf ein die Prüfposition der Prüfspitze definierender Anschlag vorgesehen.

Ausgehend von einer Prüfvorrichtung für einen elektrischen Steckverbinder, der in einer Rasteranordnung mehrere Schneidkontaktfedern mit jeweils dazu elektrisch kontaktierten elektrischen Leitern aufweist, wird in einer Weiterbildung der Prüfvorrichtung vorgeschlagen, daß diese entsprechend des Rasters eine entsprechende Anzahl Prüfstifte an der Halteeinrichtung sowie Prüfspitzen am Prüfkopf aufweist. Auf diese Weise ist es möglich, durch eine einzige Verschiebebewegung des Prüfkopfes eine komplette Überprüfung sämtlicher elektrischer Leiter beispielsweise in Form einer Flachbandleitung des elektrischen Steckverbinders vorzunehmen. Die Prüfspitzen bilden dabei eine Prüfleiste, die mit dem Raster der elektrischen Steckverbindung korrespondiert.

Ein Ausführungsbeispiel einer erfindungsgemäßen Prüfvorrichtung zum Prüfen der richtigen Lage eines an einem elektrischen Steckverbinder in Schneidklemmtechnik elektrisch kontaktierten elektrischen Leiters wird nachfolgend anhand der Zeichnungen beschrieben. In diesen zeigt:

Fig. 1 eine teilweise geschnittene schematische Ansicht der Prüfvorrichtung, wobei sich der Prüfkopf in Ruhelage befindet;

Fig. 2 die Prüfvorrichtung aus Fig. 1 nach dem Verfahren des Prüfkopfes in die Prüfposition mit einem positiven Prüfergebnis;

Fig. 3 eine Darstellung entsprechend Fig. 2, jedoch mit einem negativen Prüfergebnis, wobei der elektrische Leiter nicht weit genug eingelegt worden ist;

Fig. 4 eine Darstellung entsprechend Fig. 2 ebenfalls mit einem negativen Prüfergebnis, wobei der elektrische Leiter aus der Höhenlage versetzt ist.

Die Prüfvorrichtung zum Prüfen der richtigen Lage eines an einem elektrischen Steckverbinder 1 in der sogenannten Schneidklemmtechnik elektrisch kontaktierten elektrischen Leiters 2 weist eine Halteeinrichtung 3 auf, in der der elektrische Steckverbinder 2 in einer vorgegebenen Position fixiert ist. Zu diesem Zweck ist das aus Kunststoff bestehende Steckergehäuse 4 des elektrischen Steckverbinders 1 zwischen zwei Elementen der Halteeinrichtung 3 festgelegt. Im oberen Element dieser Halteeinrichtung 3 ist ein senkrecht nach unten ragender Prüfstift 5 angeordnet, der entgegen der Kraft einer Feder 6 nach oben verschiebbar ist. An den Prüfstift 5 ist eine Prüfleitung 7 angeschlossen, die zu einer nicht dargestellten elektrischen Auswerteeinrichtung führt.

Die Prüfvorrichtung besteht weiterhin aus einem Prüfkopf 8, der bezüglich zur Halteeinrichtung 3 in Richtung des Doppelpfeiles verfahrbar ist. Am vorderen Ende dieses Prüfkopfes 8 ist ein Prüfstift 9 mit einer konisch sich verjüngenden Spitze angeordnet. Dieser Prüfstift 9 ist an eine Prüfleitung 10 angeschlossen, die ebenfalls zur bereits erwähnten, nicht dargestellten Auswerteeinrichtung führt.

Der elektrische Steckverbinder 1 besteht aus einem - bereits erwähnten - Steckergehäuse 4 aus Kunststoff. In diesem ist eine Schneidkontaktfeder 11 aus metall angeordnet. Diese besteht aus einem Federkontakt 12 in Form einer Gabelfeder, zwischen deren Zinken ein korrespondierender Kontaktstift der elektrischen Steckverbindung eingeschoben werden kann. Einstückig am Federkontakt 12 angeformt ist ein Schneidklemmkontakt 13, zwischen dessen beiden Messer ein Spalt definiert ist. In diesen Spalt ist der elektrische Leiter 2 in der sogenannten Schneidklemmtechnik derart festgelegt, daß die beiden Messer das Isolationsmaterial 14 des elektrischen Leiters 2 anritzen und im elektrischen Kontakt mit dem Draht 15 des elektrischen Leiters 2 stehen. Das Ende des elektrischen Leiters 2 liegt dabei im kontaktierten Zustand hinter einem im Steckergehäuse 4 ausgebildeten Fenster 16.

Die Prüfvorrichtung ist in den Zeichnungen nur anhand einer einzigen Schneidkontaktfeder 11 sowie einem einzigen elektrischen Leiter 2 dargestellt. In der Praxis werden aber in einem Raster mehrere Schneidkontaktfedern 11 nebeneinander und daher auch entsprechend mehrere elektrische Leiter 2 im Steckergehäuse 4 angeordnet sein. Entsprechend sind bei der Prüfvorrichtung die Prüfstifte 5 der Halteeinrichtung 3 sowie die Prüfstifte 9 am Prüfkopf 8 in einer Prüfleiste angeordnet.

Im nachfolgenden soll nunmehr die Funktionsweise der Prüfvorrichtung beschrieben werden:

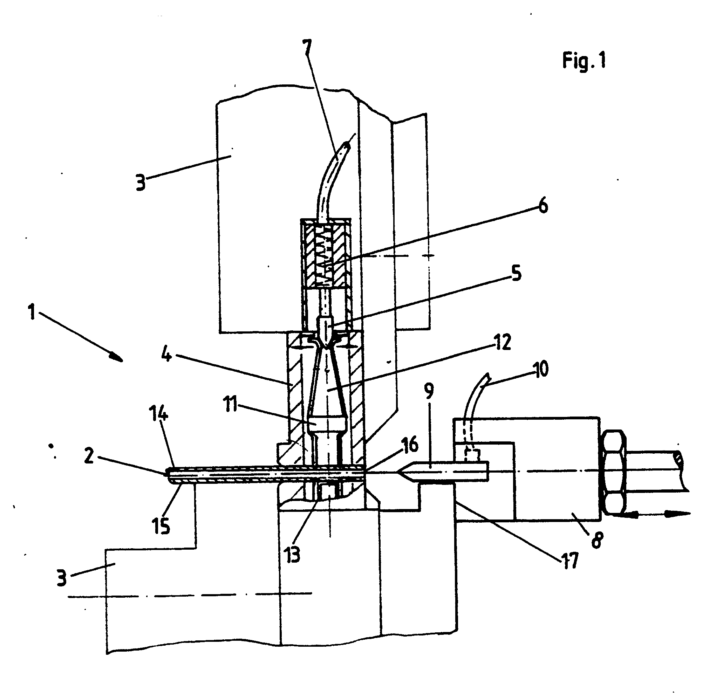

In Fig. 1 ist die Ruhelage des Prüfkopfes 8 dargestellt. Mittels dieses Prüfkopfes 8 soll nun die richtige Lage des elektrischen Leiters 2 überprüft werden. Zu diesem Zweck wird der Prüfkopf 8 und damit der Prüfstift 9 in der Zeichnung nach links verfahren, bis er an einem Anschlag 17 der Halteeinrichtung 3 anstößt. In dieser Stellung befindet sich der Prüfkopf 8 in der Prüfposition, anhand der die richtige Lage des elektrischen Leiters 2 überprüft werden soll, wobei die vordere Spitze des Prüfstiftes 9 die Sollposition des Endes des elektrischen Leiters 2 definiert.

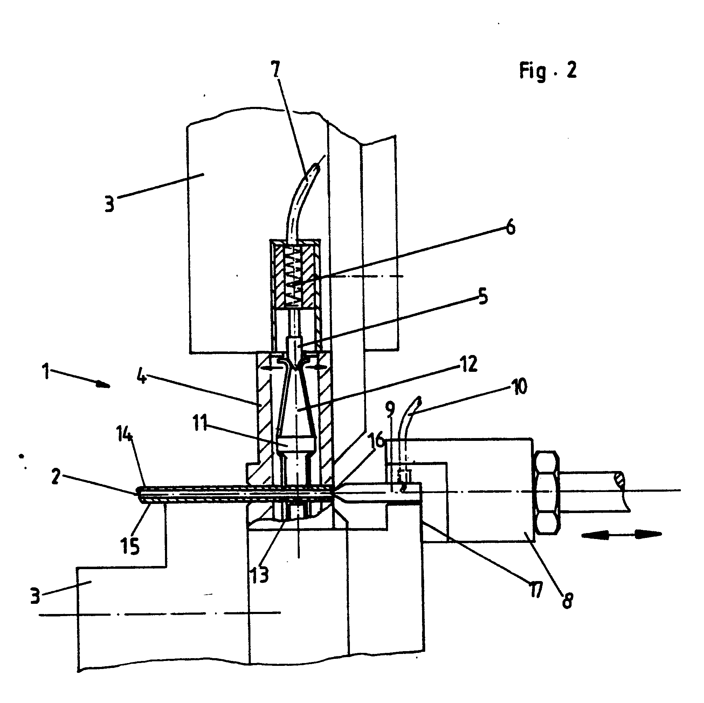

In Fig. 2 ist erkennbar, daß die Spitze des Prüfstiftes 9 am Ende des Drahtes 15 des elektrischen Leiters 2 liegt, so daß ein elektrischer Kontakt hergestellt ist. Über die Prüfleitungen 7 und 10 kann ein Prüfpotential angelegt werden. Da der Prüfstift 5 der Halteeinrichtung 3 in elektrischem Kontakt mit dem Federkontakt 12 der Schneidkontaktfeder 11, der Draht 15 mit dem Schneidklemmkontakt 13 und der Prüfstift 9 mit dem Draht 15 des elektrischen Leiters 2 in elektrischem Kontakt steht, fließt ein Strom, der besagt, daß die Kontaktierung einwandfrei ist, insbesondere daß die Lage des elektrischen Leiters 2 richtig ist.

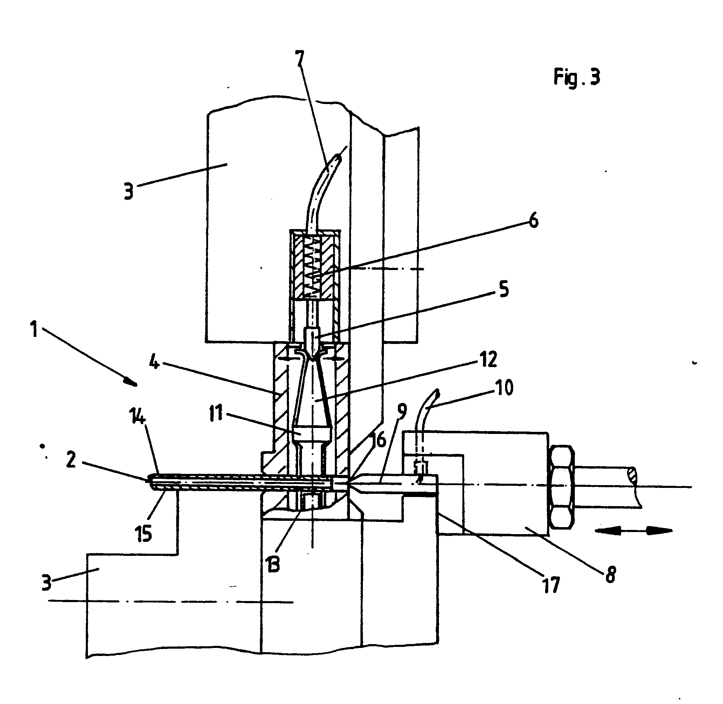

In Fig. 3 ist erkennbar, daß das Ende des elektrischen Leiters 2 nicht weit genug eingelegt ist, so daß zwischen der Spitze des Prüfstiftes 9 des Prüfkopfes 8 und dem Draht 15 des elektrischen Leiters 2 ein Zwischenabstand existiert. Durch diesen Zwischenabstand ist der Stromkreis nicht geschlossen, so daß kein Strom fließt. In diesem Fall ist das Prüfergebnis negativ, da die Lage des elektrischen Leiters 2 nicht richtig ist.

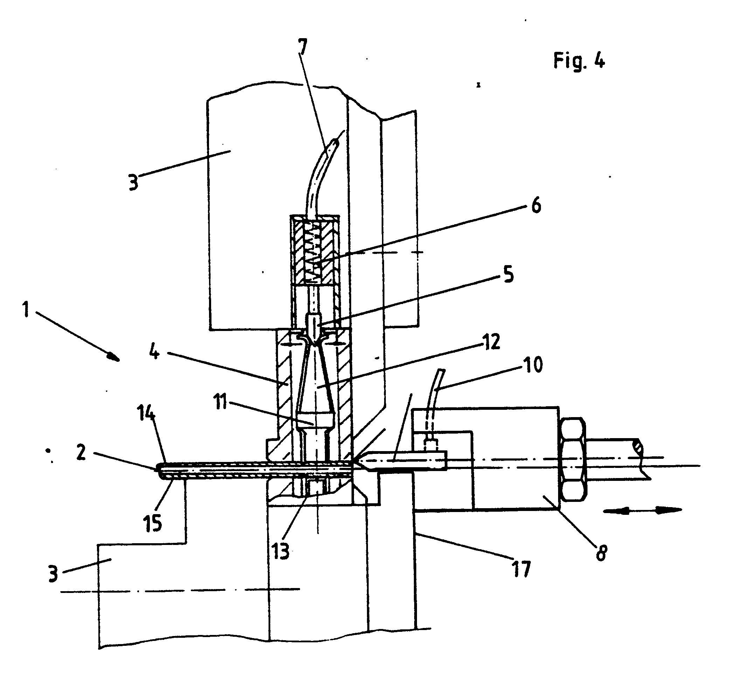

In Fig. 4 schließlich ist die Situation dargestellt, wenn der elektrische Leiter 2 in seiner Höhenlage nicht richtig in den Spalt eingesetzt worden ist. In diesem Fall trifft die Spitze des Prüfstiftes 9 auf das Isolationsmaterial 14 des elektrischen Leiters 2, so daß auch hier der elektrische Stromkreis unterbrochen und dies ein Signal dafür ist, daß der elektrische Leiter 2 nicht in der richtigen Lage kontaktiert ist.

Mittels der Prüfvorrichtung kann somit eine Aussage über die Lage des elektrischen Leiters 2 im durch den Schneidklemmkontakt 13 definierten Spalt gemacht werden, so daß damit eine Qualitätskontrolle des elektrischen Steckverbinders 1 möglich ist. Neben der richtigen Lage des elektrischen Leiters 2 kann mittels der Prüfvorrichtung noch überprüft werden, ob die Schneidkontaktfeder 11 innerhalb des Steckergehäuses 4 gebrochen und damit ebenfalls der elektrische Kontakt unterbrochen ist.

**Bezugszeichenliste**

1 elektrischer Steckverbinder
2 elektrischer Leiter
3 Halteeinrichtung
4 Steckergehäuse
5 Prüfstift
6 Feder
7 Prüfleitung
8 Prüfkopf
9 Prüfstift
10 Prüfleitung
11 Schneidkontaktfeder
12 Federkontakt
13 Schneidklemmkontakt
14 Isolationsmaterial
15 Draht
16 Fenster
17 Anschlag

**Ansprüche**

1. Prüfvorrichtung zum Prüfen der richtigen Kontaktierung sowie insbesondere der richtigen Lage eines an einem elektrischen Steckverbinder (1) in Schneidklemmtechnik elektrisch kontaktierten elektrischen Leiters (2),
wobei der elektrische Steckverbinder (1) aus einem Steckergehäuse (4) besteht, in dem eine einen Federkontakt (12) für einen Kontaktstift der elektrischen Steckverbindung sowie einen Schneidklemmkontakt (13) aufweisende Schneidkontaktfeder (11) angeordnet ist,
die Prüfvorrichtung mit einer den elektrischen Steckverbinder (1) in einer vorgegebenen Position fixierenden Halteeinrichtung (3), an der ein Prüfstift angeordnet ist, der im fixierten Zustand des elektrischen Steckverbinders (1) mit dem Federkontakt (12) der Schneidkontaktfeder (11) elektrisch kontaktiert ist, sowie mit einer am Prüfstift (5) angeschlossenen elektrischen Auswerteeinrichung zum Anlegen eines Prüfsignals,
**gekennzeichnet durch**
einen eine Prüfspitze aufweisenden und bezüglich zur Halteeinrichtung (3) derart verfahrbaren Prüfkopf (8), daß beim Verfahren in eine vorgegebene Position das vordere Ende der Prüfspitze mit dem hinter einem von außen zugänglichen Fenster (16) im Steckergehäuse (4) liegenden Ende des elektrischen Leiters (2) elektrisch kontaktiert ist, sofern sich dieses in seiner Sollposition befindet, wobei die elektrische Auswerteeinrichtung außer am Prüfstift (5) noch an dieser Prüfspitze des Prüfkopfes (8) angeschlossen ist.

2. Prüfvorrichtung nach Anspruch 1, dadurch gekennzeichnet, daß der Prüfstift (5) der Halteeinrichtung (3) federbelastet ist.

3. Prüfvorrichtung nach Anspruch 1 oder 2, dadurch gekennzeichnet, daß die Prüfspitze derart geometrisch geformt ist, daß ein Toleranzbereich der Lage des zu prüfenden elektrischen Leiters (2) ermittelbar ist.

4. Prüfvorrichtung nach einem der Ansprüche 1 bis 3, dadurch gekennzeichnet, daß die Prüfspitze des Prüfkopfes (8) ein Prüfstift (9) oder ein Prüfmesser ist.

5. Prüfvorrichtung nach einem der Ansprüche 1 bis 4, dadurch gekennzeichnet, daß der Prüfkopf (8) in Richtung der Längserstreckung des elektrischen Leiters (2) verfahrbar ist.

6. Prüfvorrichtung nach einem der Ansprüche 1 bis 5, dadurch gekennzeichnet, daß zwischen der Halteeinrichtung (3) und dem Prüfkopf (8) ein die Prüfposition der Prüfspitze definierender Anschlag (17) vorgesehen ist.

7. Prüfvorrichtung nach einem der Ansprüche 1 bis 6 für einen elektrischen Steckverbinder (1), der in einer Rasteranordnung mehrere Schneidkontaktfedern (11) mit jeweils daran elektrisch kontaktierten elektrischen Leitern (2) aufweist, dadurch gekennzeichnet, daß die Prüfvorrichtung entsprechend des Rasters eine entsprechende Anzahl Prüfstifte (5) an der Halteeinrichtung sowie Prüfspitzen am Prüfkopf (8) aufweist.

Fig. 1

Fig. 2

Fig. 3

EP 0 387 732 A2

Fig. 4